(19) Europäisches Patentamt
European Patent Office
Office européen des brevets

(11) EP 4 291 953 B1

(12) EUROPÄISCHE PATENTSCHRIFT

(45) Veröffentlichungstag und Bekanntmachung des Hinweises auf die Patenterteilung:
**15.04.2026 Patentblatt 2026/16**

(21) Anmeldenummer: **22708502.4**

(22) Anmeldetag: **11.02.2022**

(51) Internationale Patentklassifikation (IPC):
***G03F 7/031*** $^{(2006.01)}$ ***C08F 2/44*** $^{(2006.01)}$
***C08F 2/50*** $^{(2006.01)}$ ***G03F 7/105*** $^{(2006.01)}$
***G03F 7/00*** $^{(2006.01)}$

(52) Gemeinsame Patentklassifikation (CPC):
**G03F 7/001; C08F 2/44; C08F 2/50; G03F 7/0005; G03F 7/031; G03F 7/105;** G03H 2260/12

(86) Internationale Anmeldenummer:
**PCT/EP2022/053414**

(87) Internationale Veröffentlichungsnummer:
**WO 2022/171820 (18.08.2022 Gazette 2022/33)**

(54) **VERBESSERTES AUSBLEICHEN**

IMPROVED BLEACHING

BLANCHISSEMENT AMÉLIORÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.02.2021 EP 21156695**

(43) Veröffentlichungstag der Anmeldung:
**20.12.2023 Patentblatt 2023/51**

(73) Patentinhaber: **Xetos AG**
**85662 Hohenbrunn (DE)**

(72) Erfinder: **KNOCKE, Frank**
**85560 Ebersberg (DE)**

(74) Vertreter: **Kraus & Lederer PartGmbB**
**Thomas-Wimmer-Ring 15**
**80539 München (DE)**

(56) Entgegenhaltungen:
**JP-A- 2017 203 908**
**US-A- 4 565 769**
**US-A- 4 565 769**
**US-A1- 2011 236 803**
**US-A1- 2018 180 993**

- **MAO CHEN ET AL: "Light-Controlled Radical Polymerization: Mechanisms, Methods, and Applications", CHEMICAL REVIEWS, vol. 116, no. 17, 15 March 2016 (2016-03-15), US, pages 10167 - 10211, XP055461291, ISSN: 0009-2665, DOI: 10.1021/acs.chemrev.5b00671**
- **"Comprehensive Heterocyclic Chemistry III (exctract)", 1 January 2008, article FRAVEL: "Comprehensive Heterocyclic Chemistry III (exctract)", XP055829296**
- **ROLF DESSAUER: "Photochemistry, History and Commercial Applications of Hexaarylbiimidazoles All About HABIs", 1 January 2006 (2006-01-01), pages 1 - 249, XP055565548, Retrieved from the Internet <URL:https://epdf.pub/photochemistry-history-and-commercial-applications-of-hexaarylbiimidazoles-all-a.html> [retrieved on 20190306]**
- **ZHANG JING ET AL: "A known photoinitiator for a novel technology: 2-(4-methoxystyryl)-4,6-bis(trichloromethyl)-1,3,5-triazine for near UV or visible LED", vol. 5, no. 20, 1 January 2014 (2014-01-01), pages 6019 - 6026, XP055829301, ISSN: 1759-9954, Retrieved from the Internet <URL:https://pubs.rsc.org/en/content/articlepdf/2014/py/c4py00770k> DOI: 10.1039/C4PY00770K**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 4 291 953 B1

## Beschreibung

Die vorliegende Erfindung bezieht sich auf UV/VIS photopolymerisierbare Zusammensetzungen und daraus hergestellte Elemente sowie deren Verwendung. Besonders auf Aufzeichnungsmaterialien für optische Elemente mit Brechungsindexmodulation, insbesondere Hologramme.

Damit photopolymerisierbare Zusammensetzungen mit sichtbaren Licht gehärtet werden können, brauchen sie ein entsprechendes Photoinitiatorsystem, welches die Energie des Lichtes absorbiert, Radikale bildet und die Kettenreaktion der radikalischen Polymerisation einleitet.

Solche Systeme sind bekannt und werden z.B. in der Anmeldung DE 69032682 T2 von DuPont, WO 2010091795 A1 von Bayer und in der EP 1779196 B1 von Xetos beschrieben.

Sie verwenden einen Farbstoff als Sensibilisator und ein Boratsalz als Co-Initiator. Über die Farbe wird eingestellt, für welches Licht das System empfindlich ist. Bevorzugt werden Fluoreszenzfarbstoffe mit der komplementären Farbe der Belichtungswellenlänge verwendet, um die Energie des Lichtes effektiv zu absorbieren. Für ein grünes Licht wird z.B. ein Magenta-, für Rot ein Blau- und für Blau ein Gelbton verwendet. Für die Belichtung mit verschiedenen Wellenlängen sind auch Kombinationen möglich.

Um vorteilhaft eine hohe Lichtempfindlichkeit zu erreichen, ist eine ausreichende und deutliche Färbung der photopolymerisierbaren Zusammensetzung notwendig. Allerdings sind für die meisten Anwendungen der belichteten Elemente eine klare, transparente und farblose Schicht wünschenswert. Vorteilhaft ist, dass diese Farbstoffe nicht lichtecht sind und unter UV mehr oder weniger ausbleichen. Doch dies kann je nach Farbstoff einige Zeit und hohe Bestrahlungsstärken in Anspruch nehmen und so bleibt nach der UV-Härtung, die nach der Laserbelichtung stattfindet, meistens eine deutlich wahrnehmbare Restfärbung zurück.

## Beschreibung der Erfindung

Der vorliegenden Erfindung liegt somit die Aufgabe zugrunde, ein System bereitzustellen, welches unter UV-Licht schneller und effektiver ausbleicht. Und zwar ohne Qualitätseinbußen und zusätzliche Arbeitsschritte.

Die Aufgabe wird erfindungsgemäß gelöst durch eine photopolymerisierbare Zusammensetzung die durch UV/VIS-Bestrahlung härtbar ist, umfassend:

a) 80 bis 99,8 Gew-%eine radikalisch härtbare monomerhaltige Mischung,
b) 0,1 bis 10 Gew-% eines Photoinitiatorsystems, und
c) 0,1 bis 10 Gew.-% eines Bleichmittels,

wobei die Gesamtmenge von a), b) und c) 100 Gew.-% ergibt und wobei das Bleichmittel unter aktinischer Bestrahlung wirksam ist, wobei die Komponente c) Photoinitiatoren enthält und die verwendeten Photoinitiatoren in der Komponente c) unter der Einwirkung von aktinischer Strahlung Benzoyl- und Alkoholradikale erzeugen und bei Raumtemperatur flüssige Photoinitiatoren eingesetzt werden, die gleichzeitig als Lösungsmittel für Farbstoffe dienen können.

Weitere bevorzugte Ausführungsformen sind in den Unteransprüchen definiert.

Unter Aktinität (aktinischer Strahlung) kann man die photochemische Wirksamkeit von elektromagnetischer Strahlung unterschiedlicher Wellenlänge verstehen.

Der Begriff wird zum Beispiel bei der Bewertung der physiologischen Folgen von Laserlicht unterschiedlicher Farbe oder der spektralen Empfindlichkeit von fotografischen Filmen und Fotopapieren benutzt. In der Photochemie werden als aktinische Chemikalien solche bezeichnet, die licht- bzw. strahlungsempfindlich sind.

"Unter aktinischer Bestrahlung wirksam" kann im Sinne der vorliegenden Erfindung bedeuten, dass es zu einer Aufhellung kommt.

Vorzugsweise wird die erfindungsgemäße photopolymerisierbare Zusammensetzung für die Herstellung von Elementen mit einer Brechungsindexmodulation, insbesondere von Hologrammen verwendet. Die Herstellung dieser Elemente erfolgt im allgemeinen, indem eine räumlich oder interferometrisch modulierte Strahlung auf eine Schicht der photopolymerisierbaren Zusammensetzung, die auf einem Träger-Substrat oder einer Kopiervorlage aufgebracht ist, einwirkt. Als Träger-Substrate für die Herstellung der erfindungsgemäßen Elemente können Glas, Kunststoff, insbesondere PET, PP, PMMA, Polycarbonat oder Cellulose-Di- bzw. Triacetat, oder Papier verwendet werden. Bei der Belichtung kann sich die photopolymersierbare Zusammensetzung z.B. zwischen zwei Glasplatten befinden.

Bevorzugt ist ein Element, enthaltend eine Komponente, die erhältlich ist durch die Einwirkung von UV/VIS-Strahlung, vorzugsweise aktinischer UV/VIS-Strahlung, auf die erfindungsgemäße photopolymerisierbare Zusammensetzung.

Besonders bevorzugt ist ein Element, umfassend ein Hologramm, das erhältlich ist durch die Einwirkung einer räumlich oder interferometrisch modulierten Strahlung auf die erfindungsgemäße photopolymerisierbare Zusammensetzung.

Besonders bevorzugt ist ein erfindungsgemäßes Element, umfassend ein Hologramm, das so erhältlich ist und durch UV-Strahlung gebleicht wird.

Vorzugsweise wird ein Herstellungsverfahren verwendet, welches das Element nach der UV/VIS-Belichtung noch einmal mit UV-Licht nachbleicht.

Vorzugsweise wird das Element als Folie, Linse, Gitter, Prisma, Spiegel, Strahlteiler, Diffusor, Oberflächenrelief, optischer Schalter oder Sensor genutzt. Und besonders bevorzugt für ein Head-up-Display, eine Verbundglasscheibe, eine Datenbrille, ein Lichtleitsystem, ein Spektrometer, ein Detektionssystem, ein Sicherheitselement oder ein Label verwendet.

Ein weiterer Gegenstand der Erfindung ist ein Verfahren zur Bildung eines lichtbeständigen Hologramms in einer photopolymerisierbaren Schicht auf einer Substratoberfläche oder einer Kopiervorlage, umfassend die Einwirkung einer eine holographische Information tragenden, modulierten Strahlung auf eine Schicht der erfindungsgemäßen photopolymerisierbaren Zusammensetzung.

**Bleichmittel**

Überraschenderweise wurde gefunden, dass die Zerfallsprodukte bestimmter Photoinitiatoren, die bei der aktinischen Bestrahlung entstehen, zu einem besseren und schnelleren Ausbleichen der Farbstoffe beitragen.

Dabei handelt es sich um Photoinitiatoren, die wie folgt aufgebaut sind. Eine A-rylketonverbindung, dargestellt durch die folgende allgemeine Formel (1),

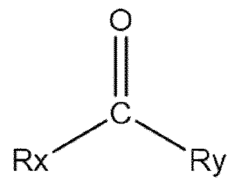

(1)

worin Rx und Ry gleich oder verschieden sind und eine gerade oder verzweigte Alkylgruppe mit 1 bis 8 Kohlenstoffatomen darstellen und gegebenenfalls mit einer Hydroxylgruppe substituiert sind, eine Cycloalkylgruppe mit 1 bis 8 Kohlenstoffatomen und gegebenenfalls substituiert mit einer Hydroxylgruppe, eine Alkoxygruppe mit 1 bis 8 Kohlenstoffatomen und gegebenenfalls substituiert mit einer Hydroxylgruppe, einer Alkoxycarbonylgruppe (deren Alkoxygruppe 1 bis 8 Kohlenstoffatome aufweist) und gegebenenfalls substituiert mit einer Hydroxylgruppe, einer Carbamoylgruppe, gegebenenfalls substituiert mit einer Phosphatgruppe, einer Phosphorylgruppe, gegebenenfalls substituiert durch eine Alkylgruppe mit 1 bis 8 Kohlenstoffatomen oder eine Arylgruppe mit 6 bis 8 Kohlenstoffatomen, eine Acylgruppe oder eine kondensierte Acylgruppe, gegebenenfalls substituiert mit einer Hydroxylgruppe, oder eine Gruppe, dargestellt durch die Formel (2);

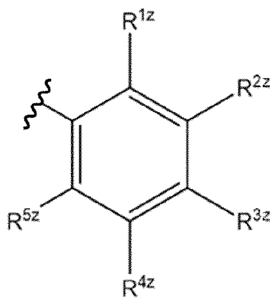

(2)

wobei in der Formel (2) $R^{1z}$ bis $R^{5z}$ gleich oder verschieden sind und ein Wasserstoffatom darstellen, eine Alkylgruppe mit 1 bis 8 Kohlenstoffatomen, eine Alkenylgruppe mit 2 bis 8 Kohlenstoffatomen, eine Alkoxygruppe mit 1 bis 8 Kohlenstoffatomen Atome, eine Alkylgruppe mit 1 bis 8 Kohlenstoffatomen und substituiert mit Halogenatomen, eine Alkoxygruppe mit 1 bis 8 Kohlenstoffatomen und substituiert mit Halogenatomen, ein Halogenatom, eine Hydroxylgruppe, eine Nitrogruppe, eine Cyanogruppe, eine Aminogruppe, wobei in der Formel (2) zwei beliebige benachbarte Gruppen von $R^{1z}$ bis $R^{5z}$ gegebenenfalls zusammenbinden, um einen kondensierten Ring zu bilden, der ausgewählt ist aus Naphthalinring, Chinolinring, Isochinolinring, Tetrahydronaphthalinring, Indanring, Tetrahydrochinolinring und Tetrahydroisochinolinring zusammen mit dem Benzolring, an den sie binden, und die Kohlenstoffatome, an die zwei benachbarte Gruppen von $R^{1z}$ bis $R^{5z}$ binden, sind gegebenenfalls mit 1 bis 4 derselben oder verschiedener Substituenten substituiert, ausgewählt aus einer Alkylgruppe mit 1 bis 8 Kohlenstoffatomen, einer Cycloalkylgruppe mit 3 bis 8 Kohlenstoffatomen, einer Alkenylgruppe mit 2 bis 8 Kohlenstoffatomen, einer Alkoxygruppe mit 1 bis 8 Kohlenstoffatomen und gegebenenfalls substituiert

mit Halogenatomen, Hydroxylgruppe, Nitrogruppe, Cyanogruppe, Aminogruppe, wobei mindestens eines von Rx und Ry durch die Formel (2) dargestellt wird.

Bevorzugt werden folgende Photoinitiatoren und Reaktionen.

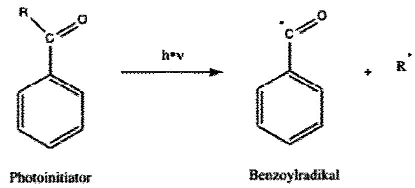


(3)

Und besonders bevorzugt 2-Hydroxy-2-methyl-1-phenylpropanone.

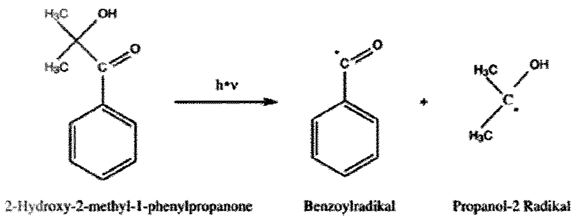


(4)

Das Bleichmittel c) in der photopolymerisierbaren Zusammensetzung umfasst einen oder mehreren dieser Photoinitiatoren oder deren Zerfallsprodukte oder ein Gemisch dieser Komponenten.

Der Anteil der geeigneten Photoinitiatoren im Bleichmittel kann mehr als 50 Gew.-%, bevorzugt mehr als 90 Gew.-% betragen. Besonders bevorzugt besteht das Bleichmittel ausschließlich aus einem oder mehreren geeigneten Photoinitiatoren.

Die Zerfallsprodukte sind Benzoylderivate und Alkohole, besonders bevorzugte Zerfallsprodukte sind Benzaldehyd und 2-Propanol.

Vorzugsweise enthält die Komponente c) der erfindungsgemäßen photopolymerisierbaren Zusammensetzung Photoinitiatoren, wobei die verwendeten Photoinitiatoren in der Komponente c) besonders bevorzugt unter der Einwirkung von aktinischer Strahlung Benzoyl- und Alkoholradikale erzeugen.

Um die gewünschten Zerfallsprodukte zu bekommen, kann auch ein Gemisch aus zwei Photoinitiatoren verwendet werden, wobei unter Bestrahlung der erste Photoinitiator das Benzoylradikal und der zweite Photoinitiator das Alkoholradikal bildet.

Besonders bevorzugt ist, dass die bleichenden Substanzen und der Bleicheffekt erst durch aktinische Bestrahlung entstehen. Damit diese Substanzen effektiv wirken können, ist eine entsprechende Dosierung notwendig, die über die sonst übliche empfohlene Menge für Photoinitiatoren liegen kann. Bevorzugt wird ein Anteil von mindestens 1 Gew.-%, besonders bevorzugt von mindestens 3 Gew.-%.

Flüssige Photoinitiatoren werden bei Raumtemperatur eingesetzt, die gleichzeitig als Lösungsmittel für die Farbstoffe dienen können. Vorzugsweise kann somit die Komponente c) als Bestandteil eines Lösungsmittel für ein Farbstoffkonzentrat verwendet werden.

Ein weiterer Gegenstand der Erfindung ist daher ein Verfahren bei dem die Komponente c) der erfindungsgemäßen photopolymerisierenden Zusammensetzung als Lösungsmittel oder als Bestandteil eines Lösungsmittels für den Farbstoff verwendet wird.

Ebenso werden Photoinitiatoren bevorzugt, die möglichst wenig unter UV-Licht vergilben.

## Monomerhaltige Mischung

Die radikalisch härtbare monomerhaltige Mischung enthält ethylenisch ungesättigte Monomere die zur radikalischen Additionspolymerisation befähigt sind. Der Anteil beträgt vorzugsweise mindestens 5 Gew.-%, bevorzugt mindestens 40 Gew.-% und besonders bevorzugt mindestens 80 Gew.-%.

Die monomerhaltige Mischung kann zudem polymere Bindemittel wie z.B. Vinylacetat (DE 69032682 T2), PMMA oder Polyole mit einem Anteil von weniger als 95%, bevorzugt von weniger als 60 Gew.-% und besonders bevorzugt von weniger als 20 Gew.-% enthalten. Anstatt in einem polymeren Binder können die Monomere auch in einer Polyurethanmatrix eingebettet sein (WO 2008/125229 A1, WO 2012/062655 A2).

Weichmacher und Additive wie Verlaufsmittel und Entlüfter, die die Filmeigenschaften verbessern, können ebenso enthalten sein. Oder andere inerte, nicht vernetzende Komponenten wie z.B. Triglyceride (EP 1 779 196 B1). Die Zutaten der Mischung sind so ausgewählt, dass die photopolymeriserbare Zusammensetzung spätestens unter aktinischer Bestrahlung eine feste Schicht ausbildet. Bevorzugt sorgen die Bestandteile der monomerhaltige Mischung dafür, dass bei einer geeigneten Belichtung der photopolymerisierbaren Zusammensetzung Brechungsunterschiede von mindestes 0,005, bevorzugt von mindestens 0,01 und besonders bevorzugt von mindestens 0,02 entstehen können. Besonders bevorzugt können Brechungsindexmodulationen mit einer Auflösung von über 1000 Linien/mm für die Aufzeichnung von Hologrammen erzeugt werden.

Vorzugsweise kann die erfindungsgemäße photopolymerisierbare Zusammensetzung eine Brechungsindexmodulation mit einer Amplitude bzw. einem $\Delta n$ von mindestens 0,005 ausbilden.

Die Brechungsindexmodulation $\Delta n$ wird mit Hilfe der Coupled Wave Theorie von Kogelnik (siehe; H. Kogelnik, The Bell System Technical Journal, Volume 48, November 1969, Number 9 Seite 2909 - Seite 2947) anhand des gemessenen Beugungswirkungsgrades (BWG) $\eta$ und der Schichtdicke d berechnet.

Für Reflexionshologramme von Oberflächenspiegeln bzw. Lippmann-Bragg-Hologramme, wo die Brechungsindexmodulation parallel zur Oberfläche verläuft, gilt folgender Zusammenhang

$$\eta = tanh^2(\frac{\pi \cdot \Delta n \cdot d}{\lambda}), \qquad \text{(F-1)}$$

wobei $\lambda$ die Wellenlänge des Lichtes ist. Für dicke Schichten kann der $\Delta n$-Wert der holographischen Aufzeichnungsmaterialien daher niedriger sein, als für dünne Schichten, um den gleichen Beugungswirkungsgrad zu erreichen.

Der Beugungswirkungsgrad kann mit einem Spektrometer (z.B. CAS 140 B von der Fa. Instrument Systems) bei Raumtemperatur in Durchlicht gemessen werden. Und zwar bei senkrechter Beleuchtung. Da das Hologramm nur die Wellenlänge reflektiert, welche die Bragg-Bedingung erfüllt, ist in der Spektralkurve an dieser Stelle ein deutlicher Absorptionspeak zu sehen.

Aus dem Peakwert $T_{Peak}$ und einem in der Nähe befindlichen Referenzwert $T_{Ref}$ auf der oberen Grundlinie berechnet sich der Beugungswirkungsgrad (BWG) $\eta$ wie folgt:

$$\eta = (T_{Ref} - T_{Peak})/T_{Ref}$$

Die Schichtdicke d kann mit einer digitalen Mikrometer-Bügelmeßschraube gemessen werden. Aus den beiden Messwerten errechnet sich die Brechungsindexmodulation wie folgt:

$$\Delta n = \frac{\lambda}{\pi \cdot d} \cdot arctanh(\sqrt{\eta}), \quad \text{(F-2)}$$

Die monomerhaltige Mischung bildet im wesentlichen klare und transparente Schichten aus, die bei Raumtemperatur fest sein können. Besonders bevorzugt sind monomerhaltige Mischungen, die in einem Temperaturbereich von 20°C bis 150°C flüssig sind. Die Viskosität sollte bei 20°C mindestens 2000mPa s, bevorzugt 10000mPa s und besonders bevorzugt mindestens 20000mPa s betragen.

Die Viskosität kann mit einem Platte-Platte-Rotationsrheometer (z.B. von der Fa. Haake, Typ 006-2805) bestimmt werden. Dabei befindet sich das Material zwischen zwei koaxialen, kreisrunden Platten von denen eine rotiert. Die Platten haben z.B. einen Abstand von 1mm und einen Durchmesser von 35mm. Aus der Messung des Drehmomentes und der Drehzahl (z.B. 10 Umdrehungen/s) kann die Viskosität ermittelt werden (DIN53018, ISO3210).

Vorzugsweise enthält die monomerhaltige Mischung mehrfach funktionelle Monomere mit mindestens zwei ethylenisch ungesättigten Gruppen. Die monomerhaltige Mischung kann ausschließlich aus einem oder mehreren difunktionellen oder höher funktionellen Monomer bestehen, d.h. die Zusammensetzung kann frei von monofunktionellen ethylenisch ungesättigten Monomeren sein. Bevorzugt beträgt der Gehalt an Monomeren mit mindestens zwei ethylenisch ungesättigten Gruppen in der Komponente c) der erfindungsgemäßen Zusammensetzung mehr als 10 Gew.% und besonders bevorzugt mehr als 30 Gew.%.

Die Verwendung von difunktionellen oder höher funktionellen Monomeren führt insbesondere zu einer besonders hohen thermischen und mechanischen Stabilität der hergestellten holographischen Elemente und ist insbesondere bei der Herstellung von Refexionshologrammen vorteilhaft.

Bevorzugte Monomere mit mindestens zwei ethylenisch ungesättigten Gruppen sind ethoxylierte Bisphenol-A-Diacrylate, insbesondere Verbindungen der folgenden Formel

wobei

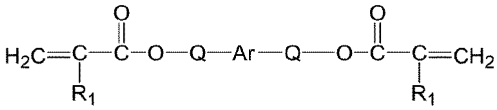

Q= 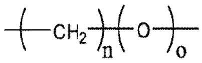 oder 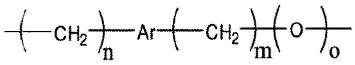

mit n, m = 0-12, vorzugsweise 1-12; o = 0, 1; und Ar ein ein- oder mehrkerniger substituierter oder unsubstituierter aromatischer oder heterocyclischer aromatischer Rest und $R_1$ ein H, Methyl oder Ethyl ist.

Ein besonders bevorzugtes Monomer ist die Verbindung der folgenden Strukturformel:

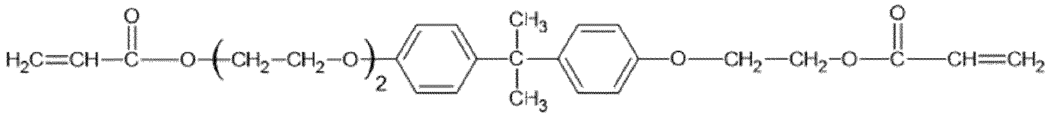

Bevorzugt beträgt die Viskosität des Monomers bzw. des Monomergemisches bei Raumtemperatur mindestens 900 mPa·s.

## Photoinitiatorsystem

Das Photoinitiatorsystem, das die Polymerisation der Monomere bei der Einwirkung aktinischer Strahlung aktiviert, besteht aus einem Photoinitiator oder einem Coinitiator bzw. Co-Photoinitiator und einem Farbstoff. Bevorzugt enthält es alle drei genannten Komponenten. Wobei der Photoinitiator von dem eventuell im Bleichmittel verwendeten Photoinitiator abweicht. Besonders bevorzugt enthält das Photoininitiatorsystem bzw. die Komponente b) nur den Coinitator und den Farbstoff. Die Begriffe "Coinitiator" und "Co-Photoinitiator" werden im Rahmen der vorliegenden Erfindung austauschbar verwendet.

Der Farbstoff dient als Sensibilisator, der die Energie der Strahlung aus dem nahen UV-, dem sichtbaren oder dem nahen Infrarot-Bereich absorbiert und die Reaktion der Radikalbildung mit Hilfe des Co-Photoinitiators in Gang bringt.

## Farbstoff

Der Farbstoff dient als Sensibilierungsmittel für den Co-Photoinitiator. Dafür eignet sich z.B. Methylenblau und die in den US-Patenten 3 554 753 A, 3 563 750 A, 3 563 751 A, 3 647 467 A, 3 652 275 A, 4 162 162 A, 4 268 667 A, 4 454 218 A, 4 535 052 A und 4 565 769 A, offenbarten Sensibilisierungsmittel, sowie die in der Anmeldung WO 2012062655 A2 genannten Farbstoffe und Co-Photoinitiatoren, auf die hierin ausdrücklich Bezug genommen wird. Zu den besonders bevorzugten Sensibilisierungsmitteln gehören die folgenden: DBC, d.h., 2,5-Bis[(4-diethylamino-2-methylphenyl)methylen]cyclopentanon; DEAW, d.h., 2,5-Bis[(4-diethylaminophenyl)methylen]cyclopentanon; Dimethoxy-JDI, d.h., 2,3-Dihydro-5,6-dimethoxy-2-[(2,3,6,7-tetrahydro-1H,5H-benzo[i,j]chinolizin-9-yl)methylen]-1H-inden-1-on; und Safranin O, d.h., 3,7-Diamino-2,8-dimethyl-5-phenyl-phenaziniumchlorid.

Vorzugsweise ist der Farbstoff in der erfindungsgemäßen photopolymerisierbaren Zusammensetzung ein Fluoreszenzfarbstoff, der beispielsweise aus einem kationischen Farbstoff und einem Anion bestehen kann. Dabei kann der kationische Farbstoff durch die Formel $F^+$ wiedergegeben werden.

Daher versteht man unter einem kationischen Farbstoff der Formel $F^+$ bevorzugt solche der folgenden Formeln:

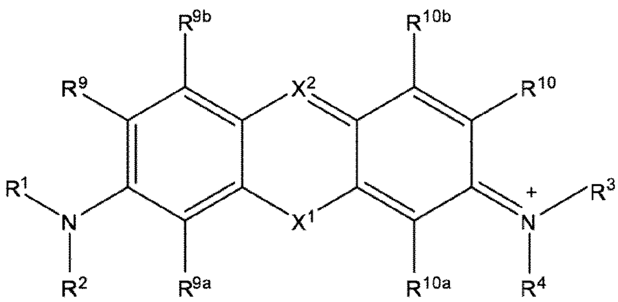

(I),

worin

$X^1$ für O, S, N-$R^6$ oder $CR^{6}aR^{6b}$ steht,

$X^2$ für N oder C-$R^5$ steht,

$R^5$ für Wasserstoff, Cyano, $C_1$- bis $C_4$-Alkyl, $C_4$- bis $C_7$-Cycloalkyl, einen ggf. durch $C_1$- bis $C_4$-Alkoxycarbonyl oder $NR^7R^8$ substituierten $C_6$- bis $C_{10}$-Aryl , einen heterocyclischen Rest oder für $C_6$- bis $C_{10}$-Aryl substituiert mit einer Carboxylgruppe steht,

$R^6$ für Wasserstoff, $C_1$- bis $C_{16}$-Alkyl, $C_4$- bis $C_7$-Cycloalkyl, $C_7$- bis $C_{16}$-Aralkyl, $C_6$- bis $C_{10}$-Aryl oder einen heterocyclischen Rest steht,

$R^{6a}$ und $R^{6b}$ unabhängig voneinander für Methyl, Ethyl oder gemeinsam für eine $-CH_2-CH_2-CH_2-$ oder $-CH_2-CH_2-CH_2-CH_2-$Brücke oder für $C_6$- bis $C_{10}$-Aryl substituiert mit einer Carboxylgruppe stehen,

bis $R^4$, $R^7$ und $R^8$ unabhängig voneinander für Wasserstoff, $C_1$- bis $C_{16}$-Alkyl, $C_4$- bis $C_7$-Cycloalkyl, $C_7$- bis $C_{16}$-Aralkyl, $C_6$- bis $C_{10}$-Aryl oder einen heterocyclischen Rest stehen oder

$NR^1R^2$, $NR^7R^4$ und $NR^7R^8$ unabhängig voneinander für einen fünf- oder sechsgliedrigen, über N angebundenen gesättigten Ring stehen, der zusätzlich ein N oder O enthalten kann und/oder durch nichtionische Reste substituiert sein kann, oder

bis $R^4$, $R^7$ und $R^8$ unabhängig voneinander mit einem zum N-Atom benachbarten C-Atom des Benzolrings eine zwei- oder dreigliedrige Brücke bilden, die ein O oder N enthalten kann und/oder durch nichtionische Reste substituiert sein kann,

$R^9$, $R^{9a}$, $R^{9b}$, $R^{10}$, $R^{10a}$ und $R^{10b}$ unabhängig voneinander für Wasserstoff, Halogen oder $C_1$ bis $C_4$-Alkyl stehen,

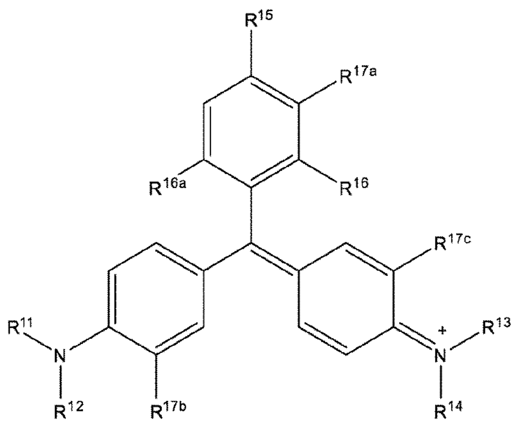
(II),

worin

$R^{15}$ für Wasserstoff, Halogen, $C_1$- bis $C_4$-Alkyl, $C_1$- bis $C_4$-Alkoxy oder $NR^{18}R^{19}$ steht,

$R^{11}$ bis $R^{14}$, $R^{18}$ und $R^{19}$ unabhängig voneinander für Wasserstoff, $C_1$ bis $C_{16}$-Alkyl, $C_4$- bis $C_7$-Cycloalkyl, $C_7$- bis $C_{16}$-Aralkyl, $C_6$- bis $C_{10}$-Aryl oder einen heterocyclischen Rest stehen oder

$NR^{11}R^{12}$, $NR^{13}R^{14}$ und $NR^{18}R^{19}$ unabhängig voneinander für einen fünf- oder sechsgliedrigen, über N angebundenen gesättigten Ring stehen, der zusätzlich ein N oder O enthalten kann und/oder durch nichtionische Reste substituiert sein kann, oder

$R^{12}$; $R^{17b}$, $R^{13}$; $R^{17c}$ und $R^{18}$; $R^{17a}$ unabhängig voneinander eine zwei- oder dreigliedrige Brücke bilden, die ein O oder N enthalten kann und/oder durch nichtionische Reste substituiert sein kann,

$R^{16}$ für Wasserstoff, Chlor, Methyl, Methoxycarbonyl oder Ethoxycarbonyl steht,

$R^{16a}$ für Wasserstoff, Chlor oder Methyl steht,

$R^{17a}$, $R^{17b}$ und $R^{17c}$ unabhängig voneinander für Wasserstoff, Chlor, Methyl oder Methoxy stehen.

Nichtionische Reste sind $C_1$- bis $C_4$-Alkyl, $C_1$- bis $C_4$-Alkoxy, Halogen, Cyano, Nitro, $C_1$- bis $C_4$-Alkoxycarbonyl, $C_1$- bis $C_4$-Alkylthio, $C_1$- bis $C_4$-Alkanoylamino, Benzoylamino, Mono-oder Di-$C_1$ - bis $C_4$-Alkylamino.

Alkyl-, Alkoxy-, Cycloalkyl-, Aryl- und heterocyclischen Reste können gegebenenfalls weitere Reste wie Alkyl, Halogen, Nitro, Cyano, CO-$NH_2$, Alkoxy, Trialkylsilyl, Trialkylsiloxy oder Phenyl tragen, die Alkyl- und Alkoxyreste können geradkettig oder verzweigt sein, die Alkylreste können teil- oder perhalogeniert sein, die Alkyl- und Alkoxyreste können ethoxyliert oder propoxyliert oder silyliert sein, benachbarte Alkyl und/ oder Alkoxyreste an Aryl- oder heterocyclischen Resten können gemeinsam eine drei- oder viergliedrige Brücke ausbilden und die heterocyclischen Reste können benzanneliert und/oder quaterniert sein.

Unter Halogen sind Fluor, Chlor, Brom oder lod zu verstehen, vorzugsweise Fluor, Chlor oder Brom.

Beispiele für substituierte Alkylreste sind Trifluormethyl, Chlorethyl, Cyanmethyl, Cyanoethyl, Methoxyethyl, Beispiele für verzweigte Alkylreste sind Isopropyl, tert.-Butyl, 2-Butyl, Neopentyl. Beispiele für Alkoxyreste sind Methoxy, Ethoxy, Methoxyethoxy.

Bevorzugte gegebenenfalls substituierte $C_1$- bis $C_4$-Alkylreste sind Methyl, Ethyl, n-Propyl, Isopropyl, n-Butyl, 2-Butyl, iso-Butyl, tert.-Butyl, perfluoriertes Methyl, perfluororiertes Ethyl, 2,2-Trifluorethyl, 3,3,3 -Trifluorethyl, Perfluorbutyl, Cyanethyl, Methoxyethyl, Chlorethyl.

Als bevorzugtes Aralkyl kommt beispielsweise Benzyl, Phenethyl oder Phenylpropyl in Frage.

Beispiele für $C_6$- bis $C_{10}$-Aryl sind Phenyl und Naphthyl. Beispiele für substituierte Arylreste sind Tolyl, Chlorphenyl, Dichlorphenyl, Methoxyphenyl, Nitrophenyl, Cyanophenyl, Dimethylaminophenyl, Diethylaminophenyl.

Beispiele für Hetarylreste, insbesondere für fünf- oder sechsgliedrige heterocyclische Reste, sind Indolyl, Pyridyl, Chinolyl, Benzthiazolyl. Beispiele für substituierte heterocyclische Reste sind 1,2-Dimethylindol-3-yl, 1-Methyl-2-phenylindol-3-yl.

Anionen für die kationischen Farbstoffen der Formel $F^+$ können beispielsweise Anionen von den Halogenen, Sulfate, Carbonate oder Nitrate sein.

Besonders geeignete kationische Farbstoffe sind Malachit Grün, Methylenblau, Safranin O, Rhodamine der Formel III

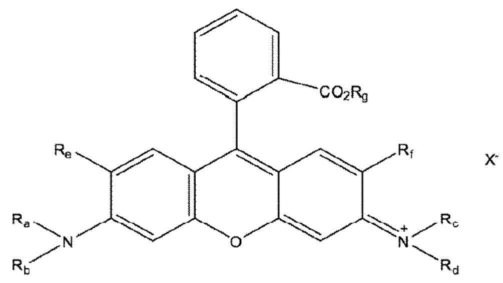

(III)

worin $R_a$, $R_b$, $R_e$, $R_d$, $R_e$, $R_f$ und $R_g$ jeweils H oder eine Alkylgruppe, und $X^-$ steht für Chloridion, Trifluoromethansulfonat, Naphthalindisulfonat, para-Toluolsulfonat, Hexafluorophosphat, Perchlorat, meta-Nitrobenzolsulfonat oder meta-Aminobenzolsulfonat, z. B. Rhodamin B, Rhodamin 6 G oder Violamin R, ausserdem Sulforhodamin B oder Sulforhodamin G, wie nachstehend aufgeführt.

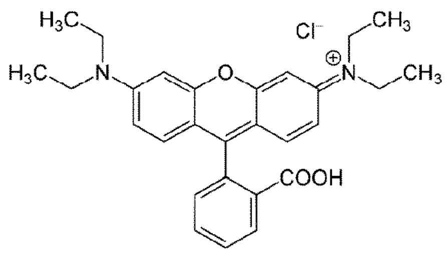

Rhodamine B

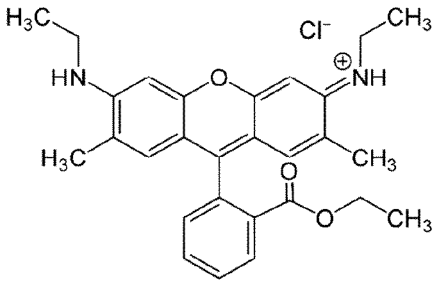

Rhodamine 6G

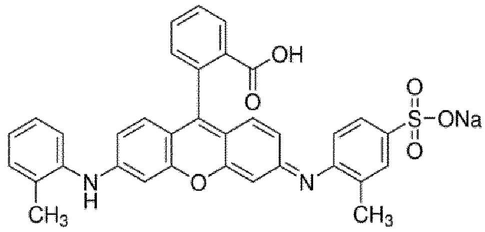

Violamin R

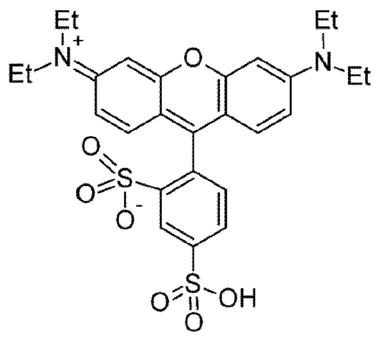

Sulforhodamin B

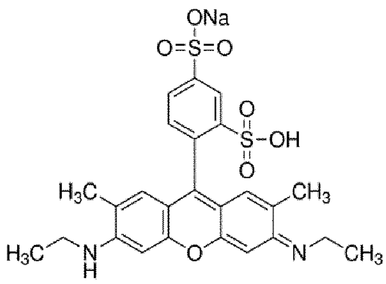

Sulforhodamin G

Andere geeignete Farbstoffe sind Fluorone, wie sie z. B. von Neckers et al. in J. Polym. Sci., Part A, Poly. Chem, 1995, 33, 1691-1703 beschrieben sind. Besonders interessant ist

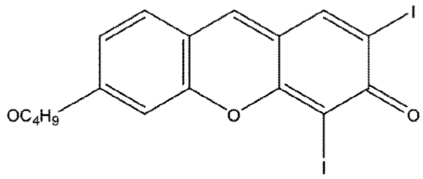

Beispiele für weitere geeignete Farbstoffe sind Cyanine der Formel IV

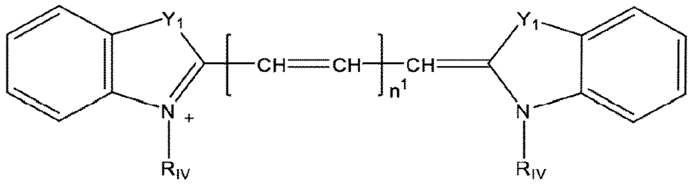

(IV)

worin $R_{IV}$ = Alkyl; $n^1$ = 0, 1, 2, 3 oder 4 und $Y_1$ = CH=CH, N-$CH_3$, $C(CH_3)_2$, O, S oder Se bedeutet. Bevorzugt sind Cyanine, worin $Y_1$ in Formel IV $C(CH_3)_2$ oder S ist.

Vorzugsweise ist der Farbstoff in der erfindungsgemäßen photopolymerisierbaren Zusammensetzung ausgewählt aus der Gruppe, bestehend aus Acriflavinen, Diaminoacridinen, Rhodamin B, Safranin-O, Diethylsafranin und Methylenblau.

## Photoinitiator

Vorzugsweise enthält das Photoinitiatorsystem bzw. die Komponente b) der photopolymerisierbaren Zusammensetzung einen Photoinitiator.

Vorzugsweise kann der Photoinitiator in der erfindungsgemäßen photopolymersierbaren Zusammensetzung bei einer Bestrahlung mit einer Wellenlänge zwischen 100 nm und 480 nm, bevorzugt zwischen 150nm und 460nm und besonders bevorzugt zwischen 200nm und 380 nm Radikale bilden.

Radikalbildende Polymerisationsintitiatoren sind bekannt, vgl. z.B. Timpe, H.J. und S. Neuenfeld, "Dyes in photoinitiator systems", Kontakte (1990), Seiten 28-35 und Jakubiak, J. und J.F. Rabek, "Photoinitiators for visible light polymisation", Polimery (Warschau) (1999), 44, Seiten 447-461.

Zu den geeigneten radikalbildenden Polymerisationsinitiatoren, die durch UV-Strahlung aktivierbar und im allgemeinen bei Temperaturen bis zu 185°C inaktiv sind, gehören die substituierten oder unsubstituierten mehrkernigen Chinone; dabei handelt es sich um Verbindungen mit zwei intracyclischen Kohlenstoff-Atomen in einem konjugierten carbocyclischen Ringsystem, z.B. 9,10-Anthrachinon, 1-Chloranthrachinon, 2-Chloranthrachinon, 2-Methylanthrachinon, 2-Ethylanthrachinon, 2-tert-Butylanthrachinon, Octamethylanthrachinon, 1,4-Naphthochinon, 9,10-Phenanthrenchinon, 1,2-Benzanthrachinon, 2,3-Benzanthrachinon, 2-Methyl-1,4-naphthochinon, 2,3-Dichlornaphthochinon, 1,4-Dimethylanthrachinon, 2,3-Dimethylanthrachinon, 2-Phenylanthrachinon, 2,3-Diphenylanthrachinon, Natrium-Salz von Anthrachinon-α-sulfonsäure, 3-Chlor-2-methylanthrachinon, Retenchinon, 7,8,9,10-Tetrahydronaphthacenchinon und 1,2,3,4-Tetrahydrobenz[a]anthracen-7,12-dion. Weitere Photoinitiatoren, die ebenfalls brauchbar sind, wenn auch manche bei so niedrigen Temperaturen wie 85°C thermisch aktiv sind, sind in US-Patent 2 760 663 beschrieben, und zu ihnen zählen vicinale Ketaldonylalkohole wie etwa Benzoin, Pivaloin, Acyloinether, z.B. Benzoinmethyl- und -ethylether, α-Kohlenwasserstoff-substituierte aromatische Acyloine, darunter α-Methylbenzoin, α-Allylbenzoin und α-Phenylbenzoin.

Als Photoinitiator verwendbar sind photoreduzierbare Farbstoffe und Reduktionsmittel wie etwa die in den US-Patenten 2 850 445, 2 875 047, 3 097 096, 3 074 974, 3 097 097, 3 145 104 und 3 579 339 offenbarten, sowie Farbstoffe aus der Klasse der Phenazine, Oxazine und Chinone; Michlers Keton, Benzophenon, 2,4,5-Triphenylimidazolyl-Dimere mit Wasserstoff-Donoren und deren Mischungen, wie beschrieben in den US-Patenten 3 427 161, 3 479 185, 3 549 367, 4 311 783, 4 622 286 und 3 784 557. Eine brauchbare Diskussion der farbstoffsensibilisierten Photopolymerisation findet sich in "Dye Sensitized Photopolymerization" von D.F: Eaton in Adv. in Photochemistry, Bd. 13, D.H. Volman, G.S. Hammond und K. Gollnick, Hrsg., Wiley-Interscience, New York, 1986, S. 427-487. In gleicher Weise sind auch die Cyclohexadienon-Verbindungen von US-Patent Nr. 4 341 860 als Initiatoren brauchbar. Zu den geeigneten Photoinitiatoren gehören CDM-HABI, d.h., 2-(o-Chlorphenyl)-4,5-bis(m-methoxyphenyl)-imidazol-Dimer; o-Cl-HABI, d.h., 2,2'-Bis(o-chlorphenyl)-4,4',5,5'-tetraphenyl-1,1'-biimidazol; und TCTM-HABI, d.h., 2,5-Bis(o-chlorphenyl)-4-(3,4-dimethoxyphenyl)-1H-imidazol-Dimer, die jeweils typischerweise mit einem Wasserstoff-Donor verwendet werden, z.B. 2-Mercaptobenzoxazol.

Besonders bevorzugte UV-Photoinitiatoren sind IRGACURE® OXE-01 (1,2-Octandion-1-[4-(phenylthio)-phenyl]-2-(O-benzoyloxim) und IRGACURE® OXE-02 (1-[9-Ethyl-6-(2-methylbenzoyl)-9H-carbazol-3-yl]ethanon-O-acetyloxim von der der BASF AG, sowie OMNIRAD-MBF (Methylbenzoylformiat), OMNIRAD-TPO (2,4,6-Trimethylbenzoyl-diphenyl-phosphinoxid), OMNIRAD-TPO-L (Ethyl-(2,4,6-trimethylbenzoyl)-phenylphosphinat), OMNIRAD-1173 (2-Hydroxy-2-methyl-1-phenylpropanon), OMNIRAD 1000 (Mischung aus 2-Hydroxy-2-methyl-1-phenylpropanon (80%) und 1-Hydroxycyclohexyl-phenylketon (20%)), OMNIRAD 184 (1-Hydroxycyclohexyl-phenylketon), OMNIRAD 819 (Bis(2,4,6-trimethylbenzoyl)phenylphosphinoxid), OMNIRAD 2022 (Mischung aus 2-Hydroxy-2-methyl-1-phenylpropanon, Bis(2,4,6-trimethylbenzoyl)phenylphosphinoxid und Ethyl(2,4,6-trimethylbenzoyl)-phenylphosphinat) und OMNICAT 440 (4,4'-Dimethyl-diphenyl-iodonium-hexafluorphosphat), die von IGM Resins erhältlich sind und bevorzugt in einer Menge von 0,1 bis 10 Gew.% eingesetzt werden.

| | | | | |
|---|---|---|---|---|
| 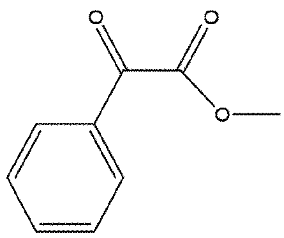 | OMNIRAD MBF | 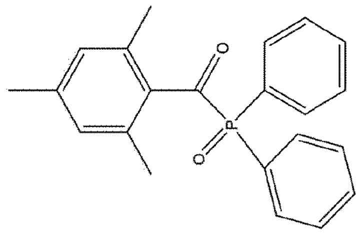 | OMNIRAD TPO | 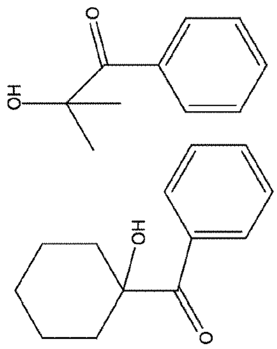 |
| 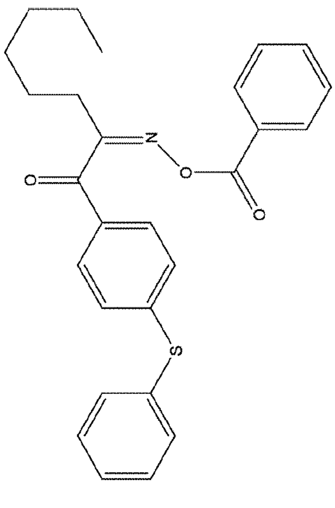 | IRCACURE® OXE-01 | 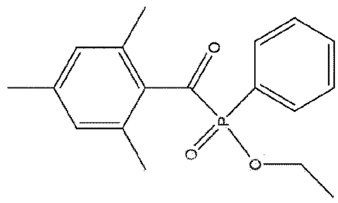 | OMNIRAD TPO-L | 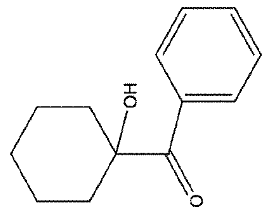 |
| | | 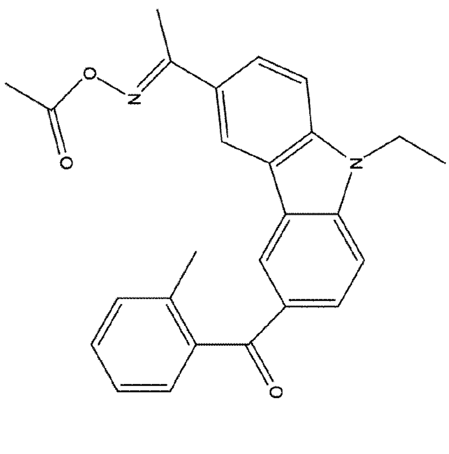 | IRGACURE® OXE-02 | 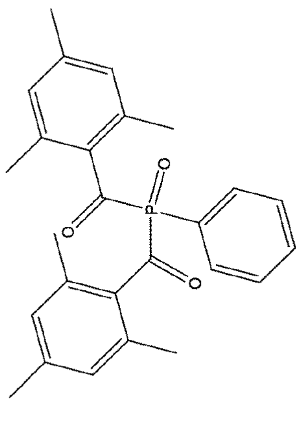 |

(fortgesetzt)

| | | |
|---|---|---|
| **OMNIRAD 819** | **OMNIRAD 184** | **OMNIRAD 1000** |
| 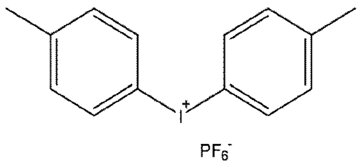 | 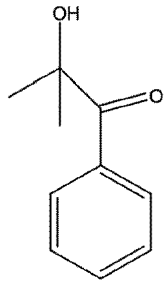 | |
| **OMNICAT 440** | **OMNIRAD 1173** | |
| 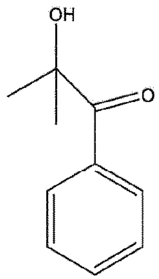 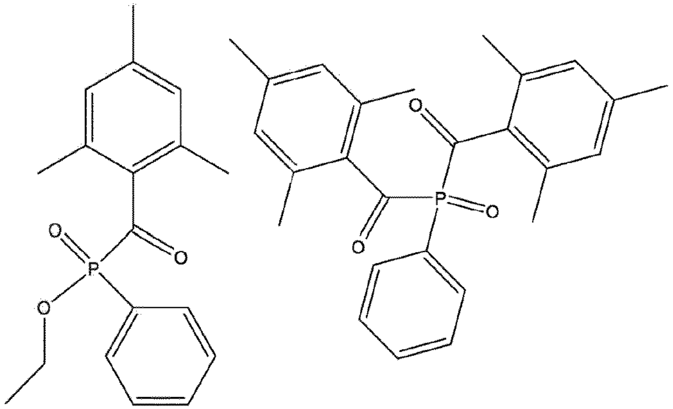 | | |
| **OMNIRAD 2022** | | |

Die voranstehend genannten Photoinitiatoren können alleine oder in Kombination eingesetzt werden.

Vorzugsweise ist der Photoinitiator flüssig ist und/oder ausgewählt ist aus der Gruppe, bestehend aus 1,2-Octandion-1-[4-(phenylthio)-phenyl]-2-(O-benzoyloxim), (1-[9-Ethyl-6-(2-methylbenzoyl)-9H-carbazol-3-yl]ethanon-O-acetyloxim, Methylbenzoylformiat), 2,4,6-Trimethylbenzoyl-diphenyl-phosphinoxid, Ethyl-(2,4,6-trimethylbenzoyl)-phenylphosphinat), 2-Hydroxy-2-methyl-1-phenylpropanon, einer Mischung aus 2-Hydroxy-2-methyl-1-phenylpropanon (80%) und 1-Hydroxycyclohexyl-phenylketon (20%), 1-Hydroxycyclohexyl-phenylketon, Bis(2,4,6-trimethylbenzoyl)phenylphosphinoxid, einer Mischung aus 2-Hydroxy-2-methyl-1-phenylpropanon, Bis(2,4,6-trimethylbenzoyl)phenylphosphinoxid und Ethyl(2,4,6-trimethylbenzoyl)-phenylphosphinat), und 4,4'-Dimethyl-diphenyl-iodonium-hexafluorphosphat.

Vorzugsweise enthält das Photoinitiatorsystem bzw. die Komponente b) der photopolymerisierbaren Zusammensetzung einen Co-Photoinitiator.

**Co-Photoinitiator**

Vorzugsweise umfasst der in dem erfindungsgemäßen Zusammensetzung verwendete Co-Photoinitiator eine Verbindung der Formel (I)

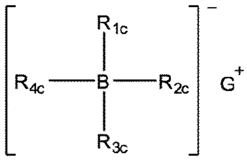

(I)

worin

$R_{1c}$ $C_1$-$C_{20}$-Alkyl, $C_3$-$C_{12}$-Cycloalkyl, $C_2$-$C_8$-Alkenyl, Phenyl-$C_1$-$C_6$-alkyl oder Naphtyl-$C_1$-$C_3$-alkyl bedeutet, wobei die Reste $C_1$-$C_{20}$-Alklyl, $C_3$-$C_{12}$-Cycloalkyl, $C_2$-$C_8$-Alkenyl, Phenyl-$C_1$-$C_6$-alkyl oder Naphtyl-$C_1$-$C_3$-alkyl mit einer oder mehreren Gruppen O, $S(O)_p$ oder $NR_{5c}$ unterbrochen sein können oder wobei die Reste $C_1$-$C_{20}$-Alkyl, $C_3$-$C_{12}$-Cycloalkyl, $C_2$-$C_8$-Alkenyl, Phenyl-$C_1$-$C_6$-alkyl oder Naphtyl-$C_1$-$C_3$-alkyl unsubstituiert oder mit $C_1$-$C_{12}$-Alkyl, $OR_6$, $R_{7c}S(O)_p$, $R_{7c}S(O)_2O$, $NR_{8c}R_{9c}$, $SiR_{10c}R_{11c}R_{12c}$, $BR_{13c}R_{14c}$ oder $R_{15c}R_{16c}P(O)_q$, substituiert sind; $R_{2c}$, $R_{3c}$ und $R_{4c}$ unabhängig voneinander Phenyl oder Biphenyl bedeuten, wobei die Reste Phenyl oder Biphenyl unsubstituiert oder mit unsubstituiertem oder mit $OR_{6c}$, $NR_{8c}R_{9c}$ oder Halogen substituiertem $C_1$-$C_{12}$-Alkyl, $OR_{6c}$, $R_{7c}S(O)_p$, $R_{7c}S(O)_2O$, $R_{8c}R_{9c}NS(O)_2$, $NR_{8c}R_{9c}$, $NR_{3c}R_{8c}CO$,

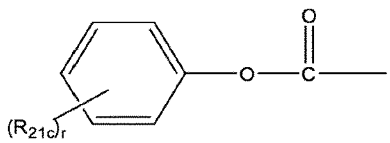

,

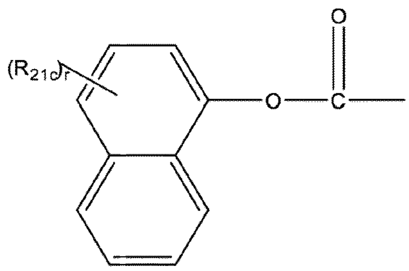

$SiR_{10c}R_{11c}R_{12c}$, $BR_{13c}R_{14c}$, Halogen, $R_{15c}R_{16c}P(O)_q$,

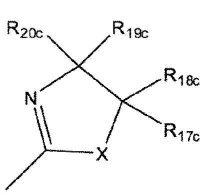

,

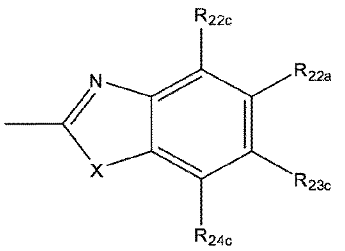

,

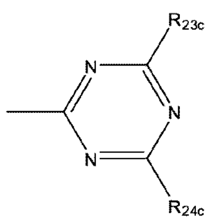

oder

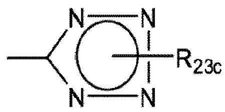

substituiert sind;

$R_{5c}$ Wasserstoff, $C_1$-$C_{12}$-Alkyl, unsubstituiertes oder ein- bis fünffach mit $C_1$-$C_6$-Alkyl, $C_1$-$C_{12}$-Alkoxy oder Halogen subsituiertes Phenyl-$C_1$-$C_6$-alkyl oder unsubstituiertes oder ein- bis fünffach mit $C_1$-$C_6$-Alkyl, $C_1$-$C_{12}$-Alkoxy oder Halogen subsituiertes Phenyl bedeutet;

$R_{6c}$ und $R_{7c}$ unsubstituiertes oder mit Halogen substituiertes $C_1$-$C_{12}$-Alkyl, unsubstituiertes oder ein- bis fünffach mit $C_1$-$C_6$-Alkyl, $C_1$-$C_{12}$-Alkoxy oder Halogen subsituiertes Phenyl-$C_1$- $C_6$-alkyl oder unsubstituiertes oder ein- bis fünffach mit $C_1$-$C_6$-Alkyl, $C_1$-$C_{12}$-Alkoxy oder Halogen subsituiertes Phenyl bedeuten;

$R_{8c}$, $R_{9c}$, $R_{10c}$, $R_{11c}$, $R_{12c}$, $R_{13c}$, $R_{14c}$, $R_{15c}$ und $R_{16c}$ unabhängig voneinander $C_1$-$C_{12}$-Alkyl, $C_3$-$C_{12}$-Cycloalkyl, unsubstituiertes oder ein- bis fünffach mit $C_1$-$C_6$-Alkyl, $C_1$-$C_{12}$-Alkoxy oder Halogen subsituiertes Phenyl-$C_1$-$C_6$-alkyl oder unsubstituiertes oder ein- bis fünffach mit $C_1$-$C_6$-Alkyl, $C_1$-$C_{12}$-Alkoxy oder Halogen subsituiertes Phenyl bedeuten, oder $R_{8c}$ und $R_{9c}$ zusammen mit dem N-Atom, an welches sie gebunden sind einen 6-gliedrigen aliphatischen Ring bilden, der ausserdem als weiteres Heteroatom Sauerstoff oder Schwefel enthalten kann;

$R_{17c}$, $R_{18c}$, $R_{19c}$ und $R_{20e}$ unabhängig voneinander Wasserstoff, unsubstituiertes oder mit $C_1$-$C_{12}$-Alkoxy substituiertes $C_1$-$C_{12}$-Alkyl, Phenyl oder Phenyl-$C_1$-$C_6$-Alkyl bedeuten, wobei die Reste Phenyl oder Phenyl-$C_1$-$C_6$-Alkyl unsubstituiert oder ein- bis fünffach mit $C_1$-$C_6$-Alkyl, $C_1$-$C_{12}$-Alkoxy oder Halogen substituiert sind; p für eine Zahl von 0 bis 2 steht;

r für eine Zahl von 0 bis 5 steht;

$R_{21c}$ für Wasserstoff oder $C_1$-$C_{12}$-Alkyl steht;

$R_{22c}$, $R_{22a}$, $R_{23c}$ und $R_{24c}$ unabhängig voneinander Wasserstoff, unsubstituiertes oder mit $C_1$-$C_{12}$-Alkoxy, OH oder Halogen substituiertes $C_1$-$C_{12}$-Alkyl oder unsubstituiertes oder mit $C_1$-$C_{12}$-Alkoxy, OH oder Halogen substituiertes Phenyl bedeuten;

q 0 oder 1 darstellt; und

G für einen Rest steht, welcher positive Ionen bilden kann.

Vorzugsweise ist der Co-Photoinitiator in der erfingungsgemäßen photopolymerisierenden Zusammensetzung ausgewählt aus der Gruppe, bestehend aus Tetrabutylammonium Tetrahexylborat, Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat oder Mischungen daraus.

Ganz besonders bevorzugt ist ein Co-Photoinitiator mit der Strukturformel Ia, die unter der Bezeichnung "CGI 7460" von Ciba Specialty Chemicals Inc. entwickelt wurde und nun unter dem Namen SEC LCA 1460 bei der BASF AG erhältlich ist, wird wie folgt dargestellt:

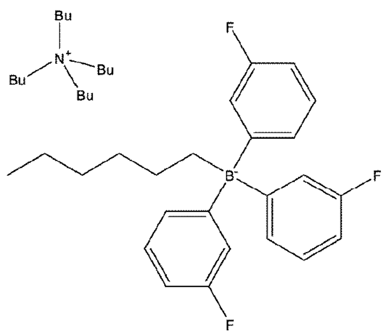

(Ia)

## Beispiele

Für die Bleichversuche wurden folgende Farbstoffe verwendet.

## Farbstoffe

| Farbstoff | CAS | Molekül |
|---|---|---|
| Safranin-O | 477-73-6 | 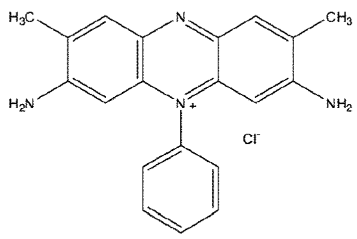 |
| Diethylsafranin | 4569-86-3 | 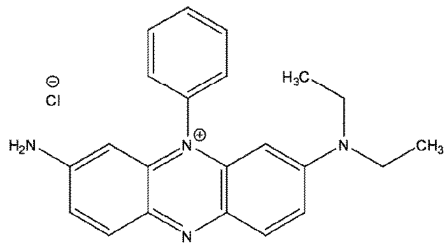 |
| Rhodamin-B | 81-88-9 | 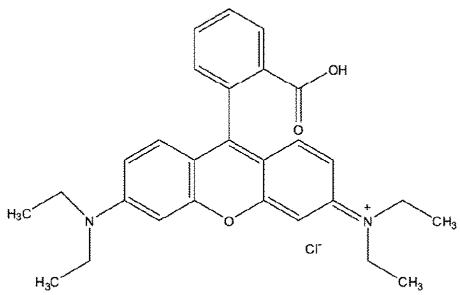 |
| Methylenblau | 61-73-4 | 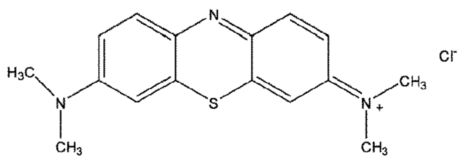 |
| Acriflavine | 8048-52-0 | 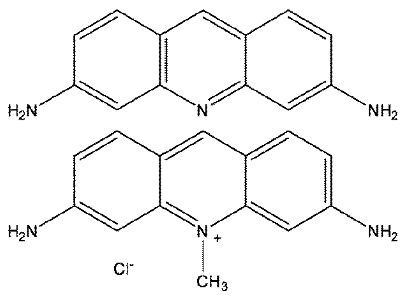 |

## UV-Initiatoren

Für die Bleichversuche wurden diese UV-Initiatoren miteinander verglichen.

**Flüssige UV-Initiatoren**

| Markenname | CAS | Molekül |
|---|---|---|
| Omnirad MBF (IGM) | 15206-55-0 | 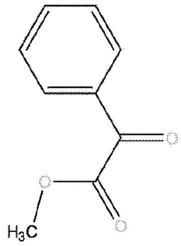 |
| Omnirad 1173 (IGM) | 7473-98-5 | 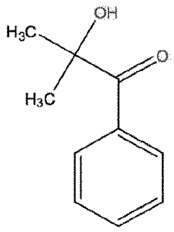 |

**Pulverförmige UV-Initiatoren**

| Markenname | CAS | Molekül |
|---|---|---|
| Omnirad 184 (IGM) | 947-19-3 | 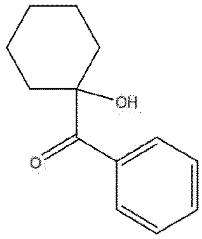 |
| Omnirad 819 (IGM) | 162881-26-7 | 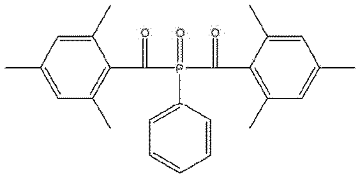 |
| Omnirad 659 (IGM) | 106797-53-9 | 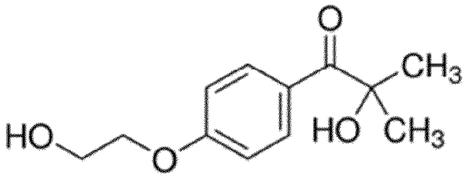 |

(fortgesetzt)

| Markenname | CAS | Molekül |
|---|---|---|
| Omnirad TPO (IGM) | 75980-60-8 | 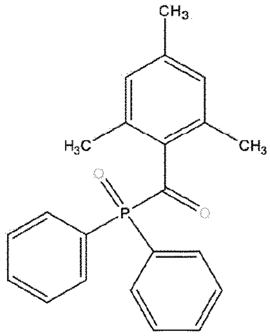 |
| OXE-01 (BASF) | 253585-83-0 | 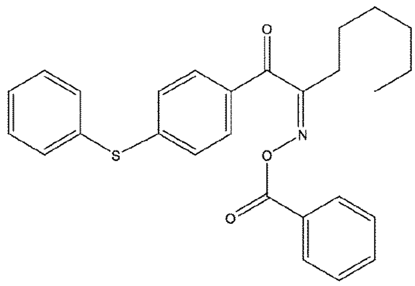 |

## Lösungsmittel

In den Bleichversuchen wurden noch folgende Lösungsmittel für die Farbstoffe und den pulverförmigen UV-Photoinitiatoren verwendet. Als Lösungsmittel, welches kein Einfluss auf das Ausbleichen hat, wurde ein niedermolekulares Polycaprolactone (PCL-triol) verwendet.

| Bezeichnung | CAS | Molekül |
|---|---|---|
| Benzaldehyd | 100-52-7 | 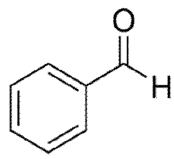 |
| 2-Propanol | 7473-98-5 | 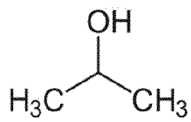 |
| Polycaprolactone triol, (PCL-triol), $M_n$ ~300 | 37625-56-2 | 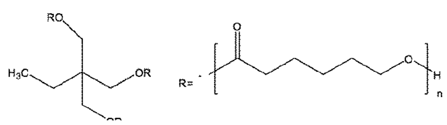 |

## Bleichversuche

Um die Eignung der Photoinitiatoren und Lösungsmittel für ein verbessertes Ausbleichen der Farbstoffe zu testen, wurden damit gesättigte Farbstofflösungen angesetzt. Dazu wurden jeweils ein bis zwei Löffelspatelspitzen (ca. 0,1 bis 0,2g) vom Farbstoff in kleinen 1,5ml Küvetten gegeben. Die pulverförmigen UV-Photoinitiatoren wurden ebenfalls mit zwei bis vier Löffelspatelspitzen (ca. 0,2 bis 0,4g) hinzugeben und das Ganze mit Polycaprolactone triol (PCL-triol) aufgefüllt. Für die Mischungen mit den flüssigen UV-Photoinitiatoren und Lösungsmitteln genügte es die Küvetten damit komplett aufzufüllen. Als Referenz wurden die puren PCL-triol Farbstoffmischungen genommen, da in diesen Lösungen kein verbessertes Ausbleichen zu beobachten ist.

Diese Mischungen wurden gut durchgemischt und ein bis zwei Stunden in einem 120°C warmen Ofen aufbewahrt. Danach kamen die Proben in eine Zentrifuge, damit sich die ungelösten Bestandteile auf den Boden absetzen. Mit einer Pipette wurden kleine Mengen von der oberen Flüssigkeit genommen und als Tropfen auf ein Objektglasträger gegeben. Rechts und links neben diesen Tropfen wurde zum Vergleich noch ein Tropfen von der Referenzlösung gegeben. Das Ganze wurde mit einer zweiten Objektglasplatte abgedeckt.

Diese Proben konnten nun gemessen und gebleicht werden. Für das Bleichen wurden die Proben 30s lang unter einer UV-Brücke mit einer Lichtbogenlänge von 70 mm und einer Leistung von 120 W/cm gelegt. Vor und nach dem Bleichen wurde die Proben visuell begutachtet und die spektralen Absorptionskurven mit einem Spektrometer gemessen.

Alle Versuche zeigten, dass die Farbstoffe am Besten in der Omnirad 1173 und der Benzaldehyd-Mischung ausbleichen. Die Zugabe von 2-Propanol bei den anderen UV-Photoinitiatormischungen konnte deren Wirkung auf das Ausbleichen teilweise verbessern.

**Photopolymerisierbare Zusammensetzungen**

Als Beispiel für den erfindungsgemäßen Effekt wurden zwei photopolymerisierbare Zusammensetzungen mit den Safranin-O Farbstoff erstellt. Dazu wurden zunächst zwei Farbstoffkonzentrate und eine monomerhaltige Mischung angemischt.

Tabelle 1

| **Farbstoffkonzentrate FK1** | | | |
|---|---|---|---|
| **Menge[g]** | **Menge[%]** | **Bezeichnung** | **CAS** |
| 14,7 | 73,5% | PCL-triol, $M_n$ ~300 | 37625-56-2 |
| 5,0 | 25,0% | OXE-01 | 253585-83-0 |
| 0,3 | 1,5% | Safranin-O | 477-73-6 |
| | | | |
| 20,00 | 100,00% | | |

Tabelle 2

| **Farbstoffkonzentrat FK2** | | | |
|---|---|---|---|
| **Menge[g]** | **Menge[%]** | **Bezeichnung** | **CAS** |
| 9,85 | 49,25% | PCL-triol, $M_n$ ~300 | 37625-56-2 |
| 9,85 | 49,25% | Omnirad 1173 | 7473-98-5 |
| 0,30 | 1,5% | Safranin-O | 477-73-6 |
| | | | |
| 20 | 100,00% | | |

Tabelle 3

| **Monomerhaltige Mischung MM1** | | | |
|---|---|---|---|
| **Menge[g]** | **Menge[%]** | **Bezeichnung** | **CAS** |
| 287,5 | 57,16% | SR 349 | 64401-02-1 |
| 212,5 | 42,25% | Ebecryl 230 | |
| 3 | 0,60% | SEC LCA 1460 | |
| | | | |
| 503,00 | 100,00% | | |

Für die holographischen Belichtungen wurden zwei photopolymerisierbaren Zusammensetzungen aus der oben aufgeführten monomerhaltigen Mischung und den beiden Farbstoffkonzentraten erstellt. Als Vergleichsbeispiel

wurde die Mischung mit den Farbstoffkonzentrat FK1 verwendet.

Tabelle 4

| Photopolymerisierbare Zusammensetzung A | | | |
|---|---|---|---|
| **Menge[g]** | **Menge[%]** | **Komponente** | **Name** |
| 5 | 97,09% | MM1 | Monomerhaltige Mischung |
| 0,15 | 2,91% | FK1 | Farbstoffkonzentrat |
| | | | |
| 5,15 | 100,00% | | |

Tabelle 5

| Photopolymerisierbare Zusammensetzung B | | | |
|---|---|---|---|
| **Menge[g]** | **Menge[%]** | **Komponente** | **Name** |
| 5 | 97,09% | MM1 | Monomerhaltige Mischung |
| 0,15 | 2,91% | FK2 | Farbstoffkonzentrat |
| | | | |
| 5,15 | 100,00% | | |

**Zubereitung**

Zuerst werden die Farbkonzentrate und die monomerhaltige Mischung erstellt. Die jeweiligen Komponenten werden nacheinander in ein Becherglas mit einem Rührmagneten gegeben. Das Becherglas steht dazu auf einer Waage, so dass die flüssigen Stoffe in der richtigen Menge hinzugegeben werden können. Danach wird alles auf einen beheizbaren Magnetrührer auf 120°C erwärmt und verrührt. Die pulverförmigen Stoffe werden mit Hilfe von Wägeschälchen dosiert und unter Rühren der Mischung zugegeben. Die Mischung wird etwa 1h lang bei 120°C gerührt, bevor die Lösung gefiltert und in einer Flasche abgefüllt wird.

Aus den Farbstoffkonzentraten und der monomerhaltigen Mischung entstehen durch Vermischen (beispielsweise durch Schütteln mit einem Speedmixer oder Verrühren mit einem Rührstäbchen) die photopolymerisierbaren Zusammensetzungen.

**Belichtungen**

Tabelle 6

| Laserbelichtungen | | | | |
|---|---|---|---|---|
| **Material** | **Peak[nm]** | **BWG[%]** | **Dicke[μm]** | **Transparenz[%]** |
| A | 536 | 86 % | 90 | 60 |
| B | 536 | 92 % | 77 | 75 |

Die photopolymerisierbaren Zusammensetzungen A und B wurden mit einem Laser mit der Wellenlänge von 532 nm in einem Temperaturbereich von 20°C bis 21°C belichtet. Die photopolymerisierbaren Zusammensetzungen wurden in einem Ofen bei 80°C aufbewahrt und kurz nach dem Auftragen belichtet. Nach der Laserbelichtung und der schnellen UV-Härtung mit einem UV-Blitz wurde mit einem Spektrometer die spektralen Absorptionskurven gemessen. Danach wurde noch einmal 30s lang unter der UV-Brücke nachgehärtet und gebleicht. Die unterschiedliche Bleichung der beiden Proben kann deutlich visuell und durch eine erneute Messung der spektralen Absorption festgestellt werden. Anhand der spektralen Absorptionskurve wurde auch der Beugungswirkungsgrad (BWG) bestimmt. Die zusätzliche Messung der Transparenz erfolgte mit einem Hazemeter. Die Schichtdicke wurde mit einer digitalen Mikrometer-Bügelmeßschraube gemessen.

**Belichtungsaufbau**

Der Laserstrahl mit einer gemessenen Leistung von 4,0 W wurde mit einem Po-lygonscanner horizontal aufgeweitet und durch eine Zylinderlinse so gebündelt, dass er eine Belichtungsbreite von 23cm abdeckte. Figur 1 zeigt den schematischen Belichtungsaufbau.

Bezugszeichen in Figur 1:

1 Laser 532nm

2 Spiegel

3 Polygonscanner

4 Zylinderlinse

5 Scanstrahl

6 Scannerspiegel

Die jeweiligen Proben wurden mit Hilfe eines verschiebbaren Spiegels mit dieser Linie abgescannt und belichtet. Die Verfahrgeschwindigkeit wurde auf 9mm/s eingestellt. Der Laserstrahl fiel mit einem Winkel von 22° zum Lot auf die Probenoberfläche.
Die Figur 2 zeigt den Strahlengang.

Bezugszeichen in Figur 2:

1 Scanstrahl 532nm

2 Scannerspiegel

3 Belichtungsrichtung

4 Belichtungswinkel, 22°

5 Substrat, Glas oder Folie

6 Photopolymer (photopolymerisierbare Zusammensetzung)

7 Master, Spiegelblech

Damit ein Reflexionshologramm entsteht wurde das Probenmaterial auf ein Spiegelblech aufgetragen, welches das Laserlicht zurückreflektiert. Durch die Interferenz des auftreffenden mit dem reflektierten Strahl entsteht parallel zur Oberfläche des Spiegels ein Linienmuster aus hellen und dunklen Stellen. Dieses Interferenzmuster wird von der photopolymerisierbaren Zusammensetzung in Form einer Brechungsindexmodulation aufgezeichnet und es entsteht ein sogenanntes Lippmann-Bragg-Hologramm.
Bei der Laserbelichtung befindet sich die Photopolymerschicht zwischen den Spiegelblech und einem transparenten Trägermaterial, z.B. eine PET-Folie oder Glas. Für die Beispiele wurden Objektglasträger verwendet. Mit dem Glas wird ein auf dem Spiegelblech aufgetragener Tropfen abgedeckt. Die Schichtdicke ergibt sich durch die Tropfenmenge und der Tropfenausdehnung. Die Größe der kreisförmigen Ausdehnung kann durch den Anpressdruck, der Temperatur und der Verlaufzeit gesteuert werden. Auch Abstandshalter (Spacer) können genutzt werden um eine bestimmte Schichtdicke zu erreichen. Nach der Laserbelichtung wird die photopolymerisierbare Zusammensetzung noch mit UV-Licht gehärtet. Für den ersten Härtungsschritt wurde ein UV-Blitz mit der Stärke von 3000 WS verwendet. Dies reicht aus um danach das Hologramm mit den Träger vom Blech zu entfernen. Damit die Haftung zum Glas

gewährleistet ist, sollte dies mit einem Primer vorbehandelt werden.

Für die endgültige Härtung und Bleichung der Probe wurde eine UV-Brücke mit einer Lichtbogenlänge von 70 mm und einer Leistung von 120 W/cm verwendet. Das Leuchtmittel war eine Quecksilberdampfbirne. Die Belichtungs- bzw. Bleichzeit betrug 30 Sekunden.

## Messaufbau

Gemessen wurden die Proben mit einem Spektrometer (CAS 140 B von der Fa. Instrument Systems) in Durchlicht. Und zwar bei senkrechter Beleuchtung. Da das Hologramm nur die Wellenlänge reflektiert, welche die Bragg-Bedingung erfüllt, ist in der Spektralkurve an dieser Stelle ein deutlicher Absorptionspeak zu sehen.

Aus dem Peakwert $T_{Peak}$ und einem in der Nähe befindlichen Referenzwert $T_{Ref}$ auf der oberen Grundlinie berechnet sich der Beugungswirkungsgrad (BWG) $\eta$ wie folgt:

$$\eta = (T_{Ref} - T_{Peak})/T_{Ref}$$

Figur 3 zeigt die Messkurve mit den entsprechenden Meßpunkten der Probe B.

Die Tabellenwerte der Belichtungen (Tab. 6) zeigen, dass beide Proben einen hohen Beugungswirkungsgrad von über 80% erreichen, die Belichtungsprobe B aber wesentlich transparenter ist. Die Figur 4 zeigt die spektralen Absorptionskurven der beiden photopolymerisierten Zusammensetzungen A und B vor und nach dem 30s langen Bleichen unter der UV-Brücke.

Die Transparenz-Werte wurden mit einem Hazemeter (haze-gard i von der Fa. BYK) unter der Verwendung einer 4mm Aperturblende nach dem ASTM D 1003 Standardverfahren gemessen.

## Patentansprüche

1. Photopolymerisierbare Zusammensetzung, die durch UV/VIS-Bestrahlung härtbar ist, umfassend:

   a) 80 bis 99,8 Gew-% einer radikalisch härtbaren monomerhaltigen Mischung,
   b) 0,1 bis 10 Gew-% eines Photoinitiatorsystems, und
   c) 0,1 bis 10 Gew.-% eines Bleichmittels,

   wobei die Gesamtmenge von a), b) und c) 100 Gew.-% ergibt und wobei das Bleichmittel unter aktinischer Bestrahlung wirksam ist, wobei die Komponente c) Photoinitiatoren enthält und die verwendeten Photoinitiatoren in der Komponente c) unter der Einwirkung von aktinischer Strahlung Benzoyl- und Alkoholradikale erzeugen und bei Raumtemperatur flüssige Photoinitiatoren eingesetzt werden, die gleichzeitig als Lösungsmittel für Farbstoffe dienen können.

2. Photopolymerisierbare Zusammensetzung nach Anspruch 1, wobei das Photoinitiatorsystem einen Farbstoff und einen Coinitiator enthält.

3. Photopolymerisierbare Zusammensetzung nach Anspruch 1 oder 2, wobei der Coinitiator ausgewählt ist aus der Gruppe, bestehend aus Tetrabutylammonium Tetrahexylborat, Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat oder Mischungen daraus.

4. Photopolymerisierbare Zusammensetzung nach einem der Ansprüche 1 bis 3, wobei der Farbstoff ausgewählt ist aus der Gruppe, bestehend aus Acriflavinen, Diaminoacridinen, Rhodamin B, Safranin-O, Diethylsafranin und Methylenblau.

5. Photopolymerisierbare Zusammensetzung nach einem der Ansprüche 1 bis 4, wobei bleichende Substanzen durch die Einwirkung von aktinischer Strahlung aus der Komponente c) entstehen.

6. Photopolymerisierbare Zusammensetzung nach einem der Ansprüche 1 bis 5, wobei die photopolymerisierbare Zusammensetzung eine Brechungsindexmodulation mit einer Amplitude bzw. einem $\Delta n$ von mindestens 0,005 ausbilden kann.

7. Element, enthaltend eine Komponente, die erhältlich ist durch die Einwirkung von UV/VIS-Strahlung, vorzugsweise

aktinischer UV/VIS-Strahlung auf die photopolymerisierbare Zusammensetzung nach einem der Ansprüche 1 bis 6.

**8.** Element nach Anspruch 7, umfassend ein Hologramm, das erhältlich ist durch die Einwirkung einer räumlich oder interferometrisch modulierten Strahlung auf die photopolymerisierbare Zusammensetzung nach einem der Ansprüche 1 bis 6.

**9.** Verwendung des Elements nach einem der Ansprüche 7 und 8, als Folie, Linse, Gitter, Prisma, Spiegel, Strahlteiler, Diffusor, Oberflächenrelief, optischen Schalter oder Sensor.

**10.** Verwendung des Elements nach einem der Ansprüche 7 und 8 für ein Head-up-Display, eine Verbundglasscheibe, eine Datenbrille, ein Lichtleitsystem, ein Spektrometer, ein Detektionssystem, ein Sicherheitselement oder ein Label.

**11.** Verfahren zur Herstellung eines Elements nach einem der Ansprüche 7 und 8 bei dem durch UV-Licht das Element nachgeblichen wird.

**12.** Verfahren bei dem die Komponente c) der photopolymerisierenden Zusammensetzung nach einem der Ansprüche 1 bis 6 als Lösungsmittel oder als Bestandteil eines Lösungsmittels für den Farbstoff verwendet wird.

**13.** Verfahren zur Bildung eines lichtbeständigen Hologramms in einer photopolymerisierbaren Schicht auf einer Substratoberfläche oder einer Kopiervorlage, umfassend die Einwirkung einer eine holographische Information tragenden, modulierten Strahlung auf eine Schicht einer photopolymerisierbaren Zusammensetzung nach einem der Ansprüche 1 bis 6.

## Claims

**1.** Photopolymerisable composition curable by UV/VIS irradiation, comprising:

a) 80 to 99.8% by weight of a radically curable monomer-containing mixture,
b) 0.1 to 10% by weight of a photoinitiator system, and
c) 0.1 to 10% by weight of a bleaching agent,

wherein the total amount of a), b) and c) is 100% by weight and wherein the bleaching agent is effective under actinic irradiation, wherein component c) contains photoinitiators and the photoinitiators used in component c) generate benzoyl and alcohol radicals under the action of actinic radiation and photoinitiators which are liquid at room temperature and can simultaneously serve as solvents for dyes are used.

**2.** Photopolymerisable composition according to claim 1,
wherein the photoinitiator system contains a dye and a co-initiator.

**3.** Photopolymerisable composition according to claim 1 or 2,
wherein the co-initiator is selected from the group consisting of tetrabutylammonium tetrahexylborate, tetrabutylammonium triphenylhexylborate, tetrabutylammonium tris-(3-fluorophenyl)-hexylborate and tetrabutylammonium tris-(3-chloro-4-methylphenyl)-hexylborate or mixtures thereof.

**4.** Photopolymerisable composition according to any one of claims 1 to 3, wherein the dye is selected from the group consisting of acriflavines, diaminoacridines, rhodamine B, safranin O, diethylsafranin and methylene blue.

**5.** Photopolymerisable composition according to any one of claims 1 to 4, wherein bleaching substances are formed from component c) by the action of actinic radiation.

**6.** Photopolymerisable composition according to any one of claims 1 to 5, wherein the photopolymerisable composition can form a refractive index modulation with an amplitude or $\Delta n$ of at least 0.005.

**7.** Element containing a component which is obtainable by the action of UV/VIS radiation, preferably actinic UV/VIS radiation, on the photopolymerisable composition according to any one of claims 1 to 6.

**8.** Element according to claim 7, comprising a hologram obtainable by exposing the photopolymerisable composition

according to any one of claims 1 to 6 to spatially or interferometrically modulated radiation.

**9.** Use of the element according to any one of claims 7 and 8 as a film, lens, grating, prism, mirror, beam splitter, diffuser, surface relief, optical switch or sensor.

**10.** Use of the element according to any one of claims 7 and 8 for a head-up display, a laminated glass pane, data glasses, a light guide system, a spectrometer, a detection system, a security element or a label.

**11.** Method for producing an element according to any one of claims 7 and 8, in which the element is post-cured by UV light.

**12.** Method in which component c) of the photopolymerising composition according to any one of claims 1 to 6 is used as a solvent or as a component of a solvent for the dye.

**13.** Method for forming a light-resistant hologram in a photopolymerisable layer on a substrate surface or a copy template, comprising exposing a layer of a photopolymerisable composition according to any one of claims 1 to 6 to modulated radiation carrying holographic information.

## Revendications

**1.** Composition photopolymérisable durcissable par irradiation UV/VIS, comprenant :

a) 80 à 99,8 % en poids d'un mélange contenant des monomères durcissables par voie radicalaire,
b) 0,1 à 10 % en poids d'un système photo-initiateur, et
c) 0,1 à 10 % en poids d'un agent de blanchiment,

la quantité totale de a), b) et c) étant de 100 % en poids et l'agent de blanchiment étant efficace sous irradiation actinique, le composant c) contenant des photo-initiateurs et les photo-initiateurs utilisés dans le composant c) générant des radicaux benzoyle et alcool sous l'effet d'un rayonnement actinique et des photo-initiateurs liquides à température ambiante étant utilisés, lesquels peuvent également servir de solvants pour les colorants.

**2.** Composition photopolymérisable selon la revendication 1,
dans laquelle le système photo-initiateur contient un colorant et un co-initiateur.

**3.** Composition photopolymérisable selon la revendication 1 ou 2,
dans laquelle le co-initiateur est choisi dans le groupe constitué par le tétrahexylborate de tétrabutylammonium, le triphénylhexylborate de tétrabutylammonium, le tris-(3-fluorophényl)hexylborate de tétrabutylammonium et le tris-(3-chloro-4-méthylphényl)hexylborate de tétrabutylammonium ou des mélanges de ceux-ci.

**4.** Composition photopolymérisable selon l'une des revendications 1 à 3, dans laquelle le colorant est choisi dans le groupe constitué par les acriflavines, les diaminoacridines, la rhodamine B, la safranine-O, la diéthylsafranine et le bleu de méthylène.

**5.** Composition photopolymérisable selon l'une des revendications 1 à 4, dans laquelle des substances blanchissantes sont formées par l'action d'un rayonnement actinique à partir du composant c).

**6.** Composition photopolymérisable selon l'une des revendications 1 à 5, dans laquelle la composition photopolymérisable peut former une modulation d'indice de réfraction avec une amplitude ou un $\Delta n$ d'au moins 0,005.

**7.** Élément contenant un composant qui peut être obtenu par l'action d'un rayonnement UV/VIS, de préférence d'un rayonnement UV/VIS actinique, sur la composition photopolymérisable selon l'une des revendications 1 à 6.

**8.** Élément selon la revendication 7, comprenant un hologramme qui peut être obtenu par l'action d'un rayonnement modulé spatialement ou interférométriquement sur la composition photopolymérisable selon l'une des revendications 1 à 6.

**9.** Utilisation de l'élément selon l'une des revendications 7 et 8, sous forme de film, de lentille, de grille, de prisme, de

miroir, de séparateur de faisceau, de diffuseur, de relief de surface, de commutateur optique ou de capteur.

**10.** Utilisation de l'élément selon l'une des revendications 7 et 8 pour un affichage tête haute, une vitre en verre feuilleté, des lunettes connectées, un système de guidage de la lumière, un spectromètre, un système de détection, un élément de sécurité ou une étiquette.

**11.** Procédé de fabrication d'un élément selon l'une des revendications 7 et 8, dans lequel l'élément est postdurci par rayonnement UV.

**12.** Procédé dans lequel le composant c) de la composition photopolymérisable selon l'une des revendications 1 à 6 est utilisé comme solvant ou comme composant d'un solvant pour le colorant.

**13.** Procédé pour former un hologramme résistant à la lumière dans une couche photopolymérisable sur une surface de substrat ou un modèle de copie, comprenant l'exposition d'une couche d'une composition photopolymérisable selon l'une des revendications 1 à 6 à un rayonnement modulé portant des informations holographiques à.

**Figur 1:**

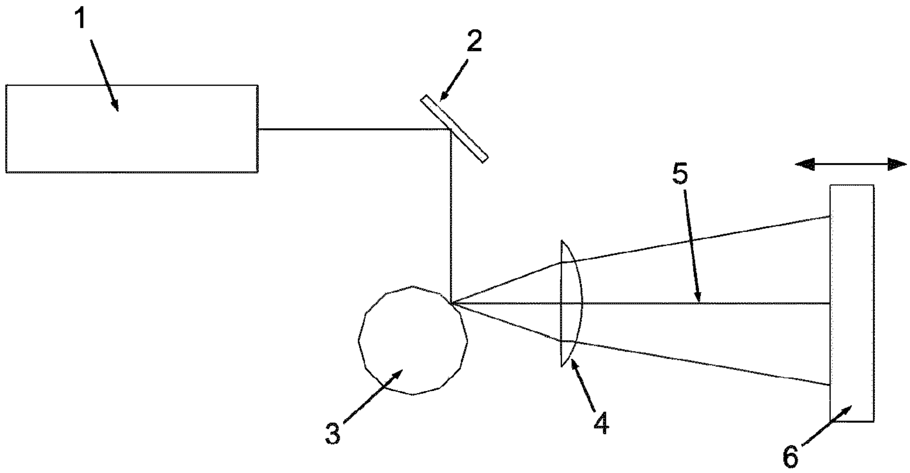

**Figur 2:**

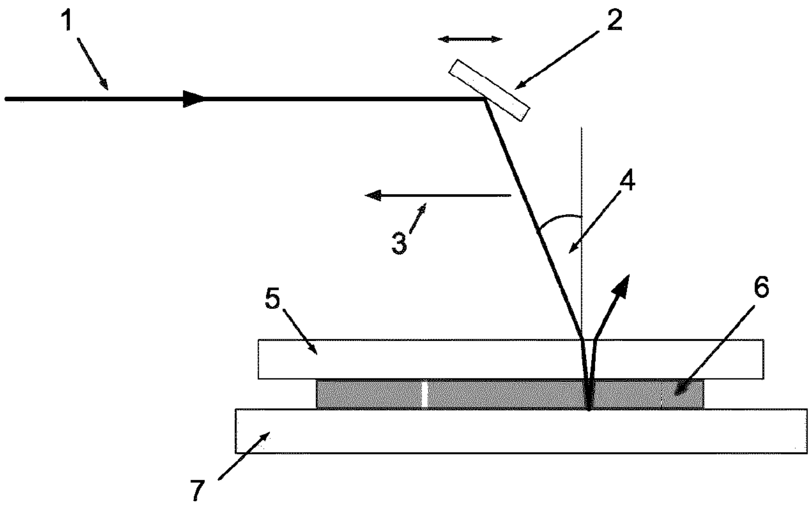

Figur 3:

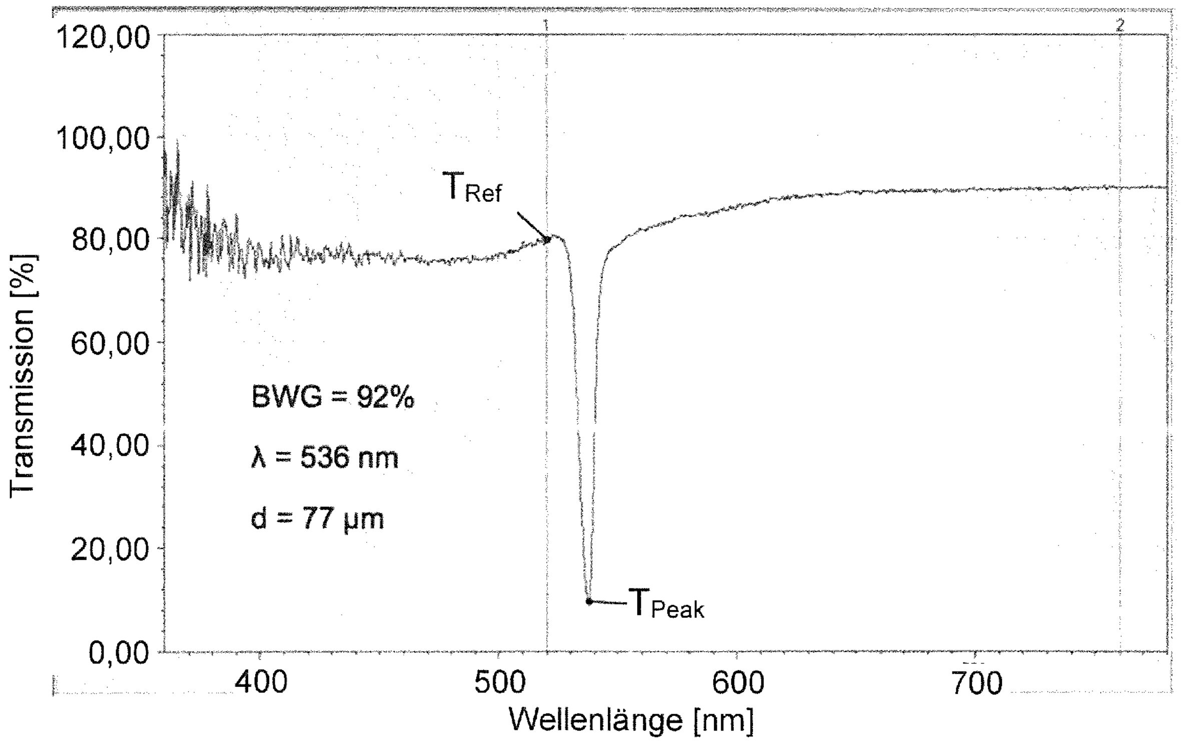
120,00
100,00
80,00
60,00
40,00
20,00
0,00
Transmission [%]
400
500
600
700
Wellenlänge [nm]
TRef
TPeak
BWG = 92%
λ = 536 nm
d = 77 µm
1
2

**Figur 4:**

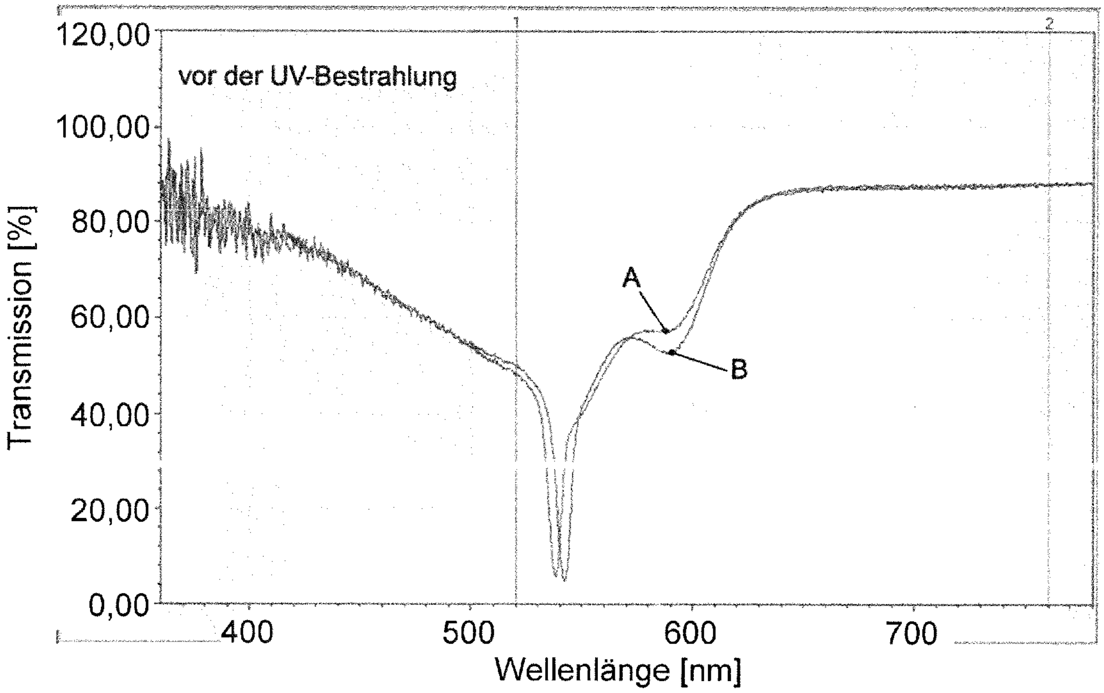
120,00
100,00
80,00
60,00
40,00
20,00
0,00
Transmission [%]
vor der UV-Bestrahlung
A
B
400
500
600
700
Wellenlänge [nm]

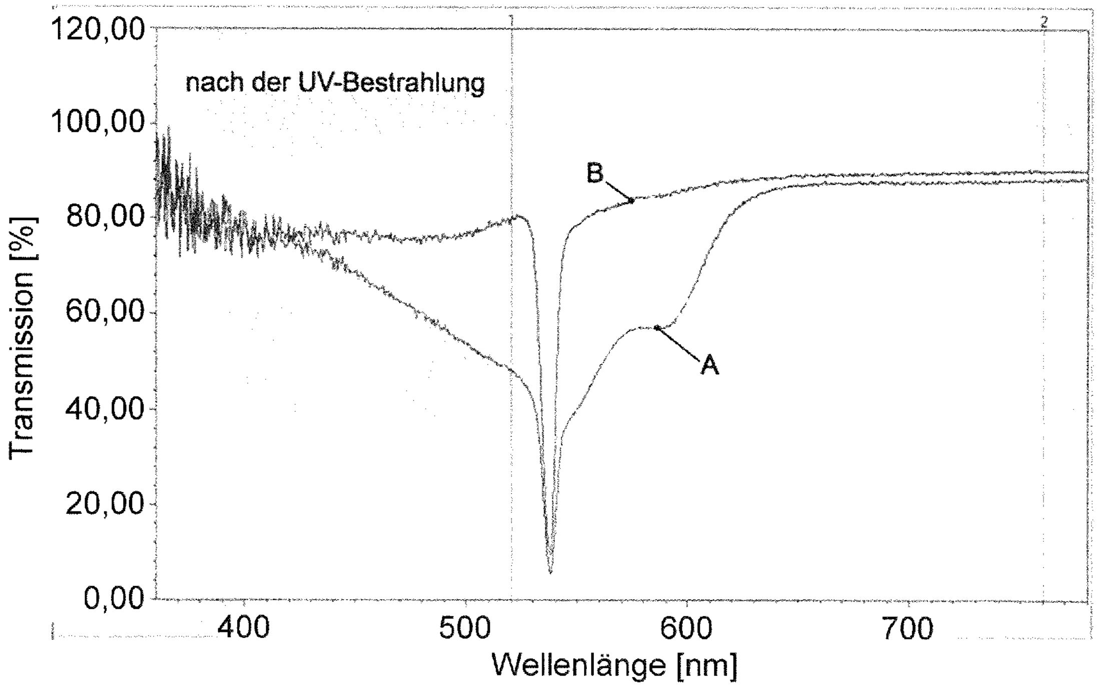
120,00
100,00
80,00
60,00
40,00
20,00
0,00
Transmission [%]
nach der UV-Bestrahlung
B
A
400
500
600
700
Wellenlänge [nm]

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- DE 69032682 T2
- WO 2010091795 A1
- EP 1779196 B1
- WO 2008125229 A1
- WO 2012062655 A2
- US 3554753 A
- US 3563750 A
- US 3563751 A
- US 3647467 A
- US 3652275 A
- US 4162162 A
- US 4268667 A
- US 4454218 A
- US 4535052 A
- US 4565769 A
- US 2760663 A
- US 2850445 A
- US 2875047 A
- US 3097096 A
- US 3074974 A
- US 3097097 A
- US 3145104 A
- US 3579339 A
- US 3427161 A
- US 3479185 A
- US 3549367 A
- US 4311783 A
- US 4622286 A
- US 3784557 A
- US 4341860 A


### In der Beschreibung aufgeführte Nicht-Patentliteratur


- **H. KOGELNIK**. *The Bell System Technical Journal*, November 1969, vol. 48 (9), 2909, 2947
- **VON NECKERS et al.** *J. Polym. Sci., Part A, Poly. Chem*, 1995, vol. 33, 1691-1703
- **TIMPE, H.J.** ; **S. NEUENFELD**. *Dyes in photoinitiator systems*, 1990, 28-35
- **JAKUBIAK, J.** ; **J.F. RABEK**. Photoinitiators for visible light polymisation. Polimery, 1999, vol. 44, 447-461
- Dye Sensitized Photopolymerization. **VON D.F: EATON** ; **D.H. VOLMAN** ; **G.S. HAMMOND** ; **K. GOLLNICK**. Adv. in Photochemistry. Wiley-Interscience, 1986, vol. 13, 427-487
- *CHEMICAL ABSTRACTS*, 477-73-6
- *CHEMICAL ABSTRACTS*, 4569-86-3
- *CHEMICAL ABSTRACTS*, 81-88-9
- *CHEMICAL ABSTRACTS*, 61-73-4
- *CHEMICAL ABSTRACTS*, 15206-55-0
- *CHEMICAL ABSTRACTS*, 7473-98-5
- *CHEMICAL ABSTRACTS*, 947-19-3
- *CHEMICAL ABSTRACTS*, 162881-26-7
- *CHEMICAL ABSTRACTS*, 106797-53-9
- *CHEMICAL ABSTRACTS*, 75980-60-8
- *CHEMICAL ABSTRACTS*, 100-52-7
- *CHEMICAL ABSTRACTS*, 37625-56-2
- *CHEMICAL ABSTRACTS*, 253585-83-0
- *CHEMICAL ABSTRACTS*, 64401-02-1